# EUROPÄISCHE PATENTSCHRIFT

(11) **EP 1 978 126 B1**
(45) Veröffentlichungstag und Bekanntmachung des Hinweises auf die Patenterteilung: **19.05.2010**
(21) Anmeldenummer: 07006980.2
(22) Anmeldetag: 03.04.2007
(51) Int. Cl.: C23C 14/04, C23C 14/56

(54) **Vorrichtung zum kontinuierlichen Beschichten eines bandförmigen Substrates**
Apparatus for continuous coating of a strip substrate
Appareil de revêtement en continu d'un substrat en forme de bande

(43) Veröffentlichungstag der Anmeldung: 08.10.2008
(73) Patentinhaber: Applied Materials, Inc., Santa Clara, CA 95054 (US)
(72) Erfinder: Multrus, Erwin, 63864 Glattbach (DE)
(74) Vertreter: Bockhorni & Kollegen

(56) Entgegenhaltungen:
- EP-A1- 0 447 550
- DE-A1- 4 310 085
- DE-C1- 4 100 643
- US-A- 4 832 983

## Beschreibung

Die Erfindung betrifft eine Vorrichtung zum kontinuierlichen Beschichten eines bandförmigen Substrates im Vakuum, insbesondere zum Herstellen von Beschichtungsmustern auf dem Substrat, mit einer Druckwalze und einer Gegendruckwalze, zwischen denen das Substrat geführt wird, wobei in einer, mit einer Stelleinrichtung einstellbaren Arbeitsstellung die Druck- und die Gegendruckwalze miteinander in Wirkverbindung stehen, bei der ein Beschichtungs- oder ein Trennmittel über die Druckwalze auf das Substrat übertragbar ist.

Vorrichtungen dieser Art werden insbesondere in Bandbeschichtungsanlagen zum kontinuierlichen Bedampfen oder Besputtern von Folienbändern- und -bahnen im Vakuum angewendet. In speziellen Ausführungen dienen sie beispielsweise zur Herstellung von Beschichtungsmustern auf dem bandförmigen Substrat, die in Längsstreifen oder über die gesamte Beschichtungsbreite des zu beschichtenden Substrates ausgebildet werden. Diese Beschichtungsmuster, auch Patternstrukturen genannt, weisen partiell beschichtungsfreie Partien auf, die durch verschiedenartige Beschichtungsmasken realisiert werden können. Bei der Maskierung durch Pattern, einer speziellen Ölabdecktechnik, werden in Anwendung dieser Technik auf die Bandbeschichtungstechnik, vor dem Aufbringen des Beschichtungsmaterials auf das Substrat die beschichtungsfreien Partien mittels eines Trennmittels, meist Öl, auf dem Substrat abgedeckt. Es ist aus dem Stand der Technik, wie z.B. aus der DE 197 32 929 A1, DE 43 10 085 A1 und die DE 41 00 643 C1, bekannt, das bandförmige Substrat, z.B. eine Folienbahn zwischen einer Druckwalze und einer Gegendruckwalze durchzuführen, wobei die Druckwalze hervorstehende Musterelemente aufweist, die mit einem Ölfilm benetzt sind, so dass beim Abrollen der Druckwalze ein Ölmuster auf dem bandförmigen Substrat aufgetragen wird. Das ölbemusterte Band wird anschließend besputtert oder bedampft, wobei sich das z.B. metallische Beschichtungsmaterial auf den ölfreien Partien des Substrates als eine Metallschicht niederschlägt und die maskierten Bereiche gegen das kondensierende Metall geschützt sind, so dass sich im Ergebnis ein trennscharfes Metallisierungsmuster auf dem Substrat ergibt. In dieser Weise werden beispielsweise Kondensatorfolien hergestellt.

Das Einstellen der Druckwalze und der Gegendruckwalze zueinander in einer Arbeitsstellung, bei der das Trennmittel auf das Substrat übertragen wird, erfolgt mittels einer Stelleinrichtung, die eine Führung für die Druckwalze oder die Gegendruckwalze, einen einstellbaren Anschlag der Führung sowie einen oder mehrere hydraulisch oder pneumatisch betätigte Druckzylinder für die Verlagerung der Walzen aufweist. Mit Betätigung der Druckzylinder wird beispielsweise die Druckwalze achsparallel zur Gegendruckwalze auf diese zu bewegt. Ebenso kann auch die Gegendruckwalze mittels des Druckzylinders auf die Druckwalze zu bewegt werden. Der einstellbare Anschlag der Führung begrenzt den jeweiligen Druckzylinderhub an einer Endstellung, die der exakten Arbeitsstellung der Druckwalze gegenüber der Gegendruckwalze entspricht. Die Position des Anschlages wird durch eine handverstellbare Einstellschraube entsprechend den Parametern des jeweiligen Patternvorganges vorgegeben. Damit werden die Walzen bei veränderlichen Parametern genauestens in der jeweils erforderlichen Arbeitstellung zu einander ausgerichtet. Mit einer Klemmschraube wird die gewählte Position des Anschlages fixiert. Den Druckzylindern entgegen gerichtete Gegendruckzylinder der Stelleinrichtung bewegen die Druckwalze von der Arbeitstellung in eine Ruhestellung, bei der die Druckwalze und die Gegendruckwalze voneinander abgestellt sind, um beispielsweise eine austauschbare Musterhülse (Sleeve) der Druckwalze mit den hervorstehenden Musterelementen wechseln zu können. Austauschbare Musterhülsen ermöglichen die Produktion bandförmiger Substrate mit den verschiedensten Mustern. Nach einem Wechsel der Musterhülsen ist eine erneute Einstellung der Arbeitsstellung erforderlich, um die korrekte Ausrichtung und den passenden Anpressdruck der Druckwalze an die Gegendruckwalze zu gewährleisten. Dazu wird die Fixierung des Anschlags von Hand gelöst und der Druckzylinder betätigt, bis die Druckwalze bündig an der Gegendruckwalze anliegt. Anschließend wird der Anschlag entsprechend dem getätigten Druckzylinderhub mittels der Einstellschraube justiert und mit der Klemmschraube fixiert. Danach wird die Bandbeschichtungsanlage vakuumdicht verschlossen, evakuiert und eine Testbeschichtung vorgenommen, mit der die Maßhaltigkeit des Beschichtungsmusters kontrolliert wird. Die exakte Einstellung der Arbeitsstellung der Walzen durch die Stelleinrichtung kann erst am beschichteten Substrat beurteilt werden. Gegebenenfalls muss der Einstellvorgang nach dem Fluten der Bandbeschichtungsanlage wiederholt werden, und zwar so lange bis die gewünschte Qualität des Beschichtungsmusters erreicht ist. Die exakte Einstellung der Arbeitsstellung der Druckwalze an der Gegendruckwalze nach einer Änderung der Parameter des Patternvorganges, wie zum Beispiel nach einem Musterhülsenwechsel, erfordert demzufolge einen hohen Zeitaufwand, der je nach der Situation mehr als ein Arbeitstag betragen kann. Diese zeit- und arbeitsintensive Einrichtung erzeugt außerdem erhebliche Produktionsstandszeiten, die zu Lasten der Wirtschaftlichkeit der Bandbeschichtungsanlage gehen.

Der Erfindung liegt daher die Aufgabe zugrunde, die Nachteile des Standes der Technik zu überwinden und die Einstellbarkeit der gattungsgemäßen Vorrichtung zu verbessern.

Die Aufgabe wird gemäß dem Patentanspruch 1 damit gelöst, dass die Stelleinrichtung zur Einstellung der Arbeitsstellung einen ansteuerbaren Stellmotor aufweist. Die in den Unteransprüchen zu Patentanspruch 1 aufgeführten Maßnahmen beschreiben vorteilhafte Weiterbildungen und Ausgestaltungen der Erfindung.

Somit muss die Einstellung der Arbeitsstellung der miteinander in Wirkverbindung stehenden Walzen nicht durch eine handbetätigte Justierung unmittelbar an der Stelleinrichtung vorgenommen werden. Wird zum Beispiel die Drehstellung der Einstellschraube, die die Position des Anschlags der Führung der Walzen vorgibt, motorisch angesteuert betrieben oder wird für die Verstellbewegung zur Abstandsänderung der Druckwalze und der Gegendruckwalze zueinander ein ansteuerbarer Stellmotor eingesetzt, kann die Einstellung der Arbeitsstellung durch Ansteuerung des/der Stellmotoren von außen, d.h. außerhalb der vakuumdichten Bandbeschichtungsanlage, vorgenommen werden. Im Ergebnis erübrigt sich das wiederholte Evakuieren und Fluten der Bandbeschichtungsanlage während des Einstellvorganges, was zu einer enormen Zeitersparnis führt. Damit verbunden sind eine erhebliche Prozessstandzeitverkürzung und eine bessere Bedienfreundlichkeit der Stelleinrichtung.

Wird der Stellmotor für die Verstellbewegung zur Verstellung eines radialen Abstandes zwischen der Druckwalze und der Gegendruckwalze eingesetzt, kann neben dem Druckzylinder für die Zuführung der Walze(n) in eine Arbeitsstellung auch der Gegendruckzylinder für die Rückführung der Walze(n) in eine Ruhestellung bei Produktionsunterbrechung entfallen, da der Stellmotor die wechselnde, entgegengesetzt gerichtete Stellbewegung der Druck- bzw. Gegendruckwalze in die Arbeitsstellung bzw. in die Ruhestellung gleichermaßen realisieren kann. Daraus ergibt sich nicht nur eine konstruktive Minimierung der Stelleinrichtung, sondern infolge der entfallenen Hydraulik- bzw. Druckluftverbindungen an die Druck- bzw. Gegendruckzylinder auch ein Wegfall der zugehörigen Leitungsdurchführungen durch die Vakuumkammerwandung der Bandbeschichtungsanlage, was zur Reduzierung der Leckagegefährdung führt.

Wird ein Schrittmotor als Stellmotor vorgesehen, kann eine besonders fein abgestufte Justage der Arbeitsstellung erfolgen. Der Schrittmotor (engl. stepper motor) ist ein Synchronmotor, der durch ein gesteuertes schrittweise rotierendes elektromagnetisches Feld exakt um einen minimalen Winkel (Schritt) oder ein genaues Vielfaches des Winkels gedreht werden kann. Wird insbesondere für die Verstellung des radialen Abstandes zwischen der Druckwalze und der Gegendruckwalze ein Schrittmotor verwendet, kann dieser Abstand in feinen Verstellschritten geändert werden, und somit eine genaue Justage der Arbeitsstellung vorgenommen werden, so dass ein mechanischer Anschlag in der Führung der Walzen zwecks Feinjustage konstruktiv entbehrlich ist. Da Schrittmotoren wegen ihres Synchronmotorverhaltens exakt dem außen angelegten elektromagnetischen Feld folgen, können sie, ohne einen Regelkreis mit Sensoren zur Positionsrückmeldung zu benötigen, mit hoher Genauigkeit direkt gesteuert betrieben werden.

Vorzugsweise ist mittels der Stelleinrichtung die Druckwalze an die Gegendruckwalze anstellbar und von dieser abstellbar. Hierbei ist die Gegendruckwalze in ihrer axialen Lage feststehend angeordnet, wobei lediglich die Druckwalze verstellbar ist, um die Arbeitsstellung und die Ruhestellung zu realisieren. Hierbei ist die Funktion der Stelleinrichtung auf die Ab- und Anstellung der Druckwalze eingeschränkt, womit sich der konstruktive Aufwand für die Stelleinrichtung weiter minimiert und gleichzeitig die Stellgenauigkeit wegen geringerer Fehlereinflüsse verbessert wird.

In einer besonders vorteilhaften Ausgestaltung weist die Stelleinrichtung einen auf einer Führungsschiene gelagerten Führungsschlitten auf, auf dem die Druckwalze angeordnet ist. Damit ist eine lineare Führung der Druckwalze möglich, die in exakter Ausrichtung senkrecht zur Drehachse der Gegendruckwalze eine achsparallele Führung der Druckwalze gegenüber der Drehachse der Gegendruckwalze in jeder Stellung gewährleistet. Mit dieser Schienenführung werden Störeinflüsse auf die Achsparallelität der Walzen beim Einstellvorgang minimiert. Die Genauigkeit wird weiter erhöht, wenn zwei Führungsschienen vorgesehen sind, auf dem der Führungsschlitten lagert. Außerdem können auf dem Schlitten weitere notwendige Bauelemente der Vorrichtung angeordnet werden, die so eine von der Stellbewegung der Walzen ungestörte, kompakte Einheit bilden. Das betrifft beispielsweise die für die Versorgung der Druckwalze mit dem Trennmittel erforderlichen Bauelemente, wie eine mit der Druckwalze in Abrollkontakt stehende Übertragungswalze mit sich anschließender Rasterwalze, der Öl von einem Ölverdampfer zugeführt wird.

Die erfindungsgemäße Vorrichtung wird nachfolgend an einem Ausführungsbeispiel näher erläutert. Die zugehörigen Zeichnungen zeigen in einer schematischen Darstellung in
- Fig. 1: eine Seitenansicht einer als Pattern Modul bezeichneten Ausführungsform der erfindungsgemäßen Vorrichtung in einer Arbeitsstellung,
- Fig. 2: eine Seitenansicht des Pattern Moduls in einer Ruhestellung und in
- Fig. 3: eine Schnittdarstellung eines Details des Pattern Moduls in Arbeitsstellung.

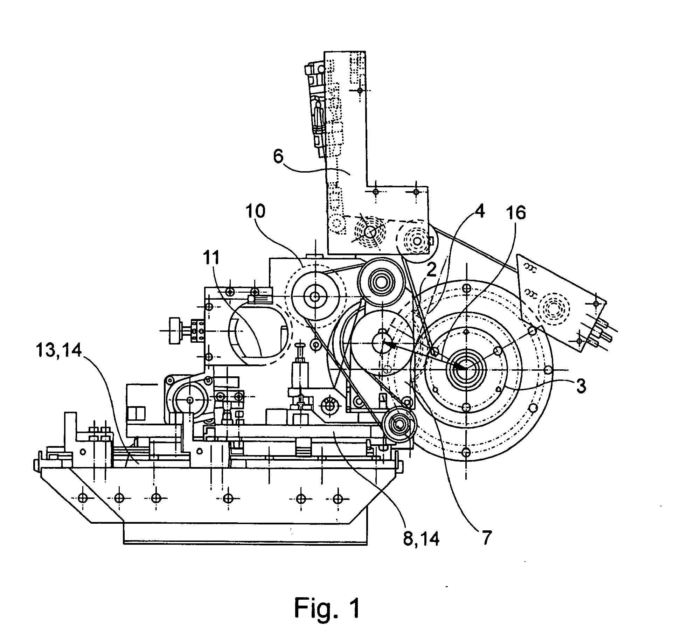

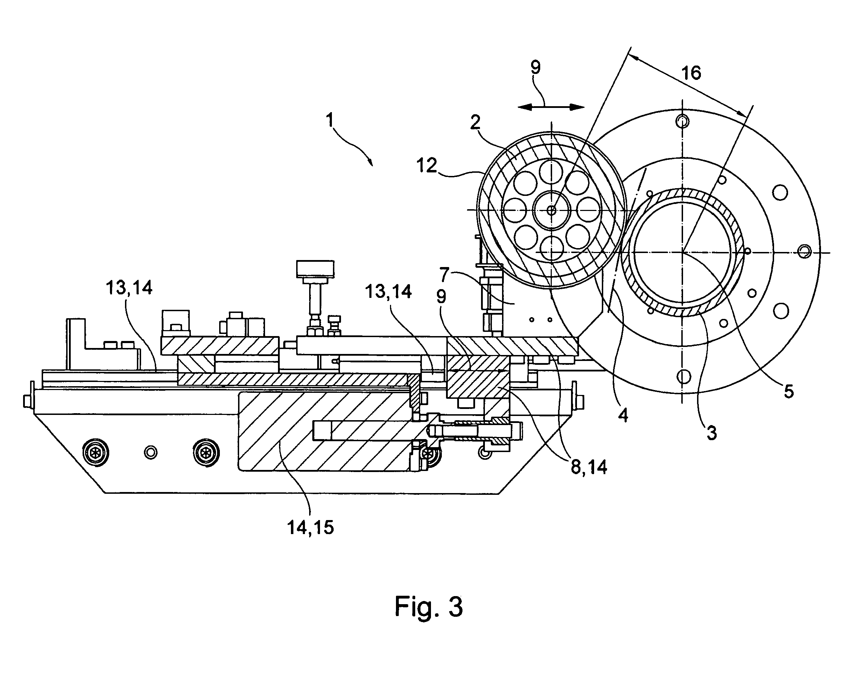

Fig. 1 bis 3 geben eine als Pattern Modul 1 bezeichnete Ausführungsform der erfindungsgemäßen Vorrichtung wieder, das Bestandteil einer nicht näher dargestellten Bandbeschichtungsanlage ist. Das Pattern Modul 1 (Anmerkung: das Bezugszeichen "1" fehlt in der neuen Fig. 1) umfasst eine Druckwalze 2 und eine mit dieser zusammenwirkenden Gegendruckwalze 3, zwischen denen das bandförmige Substrat 4, z.B. eine Kunststofffolie 4, geführt wird (in Fig. 1 und 3 angedeutet dargestellt). Die Gegendruckwalze 3 ist in einem nicht ersichtlichen, ortsfesten Lager um ihre Drehachse 5 drehbar gelagert und wird von einer Zahnradkoppelungseinrichtung 6 angetrieben.

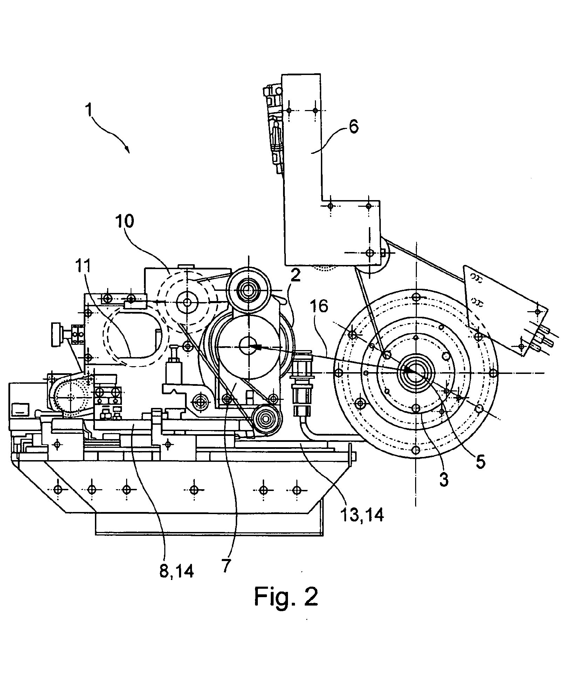

Die Druckwalze 2 ist mittels einer Walzenaufnahme 7 auf einem beweglichen Führungsschlitten 8 gelagert, der in Verfahrrichtung 9 linear verfahrbar ist. Auf dem Führungsschlitten 7 sind u. a. auch ein Ölverdampfer (verdeckt), eine Übertragungswalze 10 und eine Rasterwalze 11 angeordnet, wobei sich die Rasterwalze 11 in einem direkten Abrollkontakt mit der Übertragungswalze 10 befindet und diese wiederum mit der Druckwalze 2 in Abrollkontakt steht (ersichtlich aus Fig. 1 und 2). Ölverdampfer, Rasterwalze 11 und Übertragungswalze 10 versorgen die Druckwalze 2 mit Öl. Die Druckwalze verfügt über eine Musterhülse (Sleeve) 12, die mit dem Öl benetzt wird. Somit ist in einer Arbeitsstellung, bei der die Druck- und die Gegendruckwalze 2, 3 miteinander in Wirkverbindung stehen, also mit ihren Oberflächen unter Zwischenlage der Folie 4 aufeinander abrollen, ein Ölmuster von der Druckwalze 2 auf das Substrat 4 übertragbar (vgl. Fig. 1 und 3). Zur Übertragung des Ölmusters in der Arbeitstellung befindet sich auch die Druckwalze 2 mit der Zahnradkoppelungseinrichtung 6 in Eingriff.

Der Führungsschlitten 8 ist auf zwei beabstandete Führungsschienen 13 gelagert, wobei die Führungsschienen 13 so ausgerichtet sind, dass die auf dem Führungsschlitten 8 gelagerte Druckwalze 2 unter Einhaltung einer zur Drehachse 5 achsparallelen Lage relativ zur Gegendruckwalze 3 verschiebbar ist. Führungsschlitten 8 und Führungsschienen 13 sind Teil einer Stelleinrichtung 14, die durch je einen beidseitig der Führungsschienen 13 fest angeordneten Stellmotor 15 der Stelleinrichtung 14 betätigt wird (siehe Fig. 3). Die Stellmotoren 15 wirken auf den Führungsschlitten 8 ein und verschieben diesen gemeinsam mit der Druckwalze 2 entlang der Führungsschienen 13 in Verfahrrichtung 9, so dass die Stelleinrichtung 14 unter dem Antrieb der Stellmotoren 15 sowohl ein Anstellen der Druckwalze 2 an die Gegendruckwalze 3 sowie in einem Umkehrbetrieb der Stellmotoren 15 ein Abstellen der Druckwalze 2 von der Gegendruckwalze 3 ermöglicht. Die als Schrittmotoren 15 ausgeführten Stellmotoren 15 verschieben den Führungsschlitten 8 in vorgegebenen Verstellschritten, so dass hierbei jeder gewünschte radiale Abstand 16 zwischen der Druckwalze 2 und der Gegendruckwalze 3 einstellbar ist. Somit ist mittels dieser erfindungsgemäßen Stelleinrichtung 14 sowohl eine Arbeitsstellung des Pattern Moduls 1 nach Fig. 1 und 3, bei der die Druck- und Gegendruckwalze 2, 3 in Wirkverbindung stehen, als auch eine Ruhestellung positionierbar, bei der die Druck- und Gegendruckwalze 2,3 für eine Produktionsunterbrechung des Pattern Moduls 1 voneinander beabstandet sind (Fig. 2).

Der radiale Abstand 16 zwischen der Druckwalze 2 und der Gegendruckwalze 3 ist mittels der Schrittmotoren 15 in sehr kleinen Stellschritten verstellbar, so dass bei Bedarf insbesondere die Arbeitstellung der in Wirkverbindung stehenden Druck- und Gegendruckwalze 2, 3 genau justiert werden kann. Durch Fernansteuerung der Schrittmotoren 15 durch eine zentrale Steuereinheit außerhalb der Bandbeschichtungsanlage, kann diese Justage am evakuierten Pattern Modul 1, sogar während des Beschichtungsvorganges, vorgenommen werden.

### Bezugszeichenliste

- 1: Pattern Modul
- 2: Druckwalze
- 3: Gegendruckwalze
- 4: bandförmiges Substrat, Folie
- 5: Drehachse der Gegendruckwalze
- 6: Zahnradkoppelungseinrichtung
- 7: Walzenaufnahme
- 8: Führungsschlitten
- 9: Verfahrrichtung des Führungsschlittens
- 10: Übertragungswalze
- 11: Rasterwalze
- 12: Musterhülse
- 13: Führungsschiene
- 14: Stelleinrichtung
- 15: Schrittmotor, Stellmotor
- 16: radialer Abstand zwischen der Druckwalze und der Gegendruckwalze

## Patentansprüche

1. Vorrichtung zum kontinuierlichen Beschichten eines bandförmigen Substrates im Vakuum, insbesondere zum Herstellen von Beschichtungsmustern auf dem Substrat, mit einer Druckwalze und einer Gegendruckwalze, zwischen denen das Substrat geführt wird, wobei in einer, mit einer Stelleinrichtung einstellbaren Arbeitsstellung die Druck- und die Gegendruckwalze miteinander in Wirkverbindung stehen, bei der ein Beschichtungs- oder ein Trennmittel über die Druckwalze auf das Substrat übertragbar ist,
**dadurch gekennzeichnet, dass**
die Stelleinrichtung (14) einen ansteuerbaren Stellmotor (15) aufweist.

2. Vorrichtung nach Anspruch 1,
**dadurch gekennzeichnet, dass**
mittels des Stellmotors (15) ein radialer Abstand (16) zwischen der Druckwalze (2) und der Gegendruckwalze (3) verstellbar ist.

3. Vorrichtung nach Anspruch 1 oder 2,
**dadurch gekennzeichnet, dass**
der Stellmotor (15) als Schrittmotor (15) ausgebildet ist.

4. Vorrichtung nach einem der Ansprüche 1 bis 3,
**dadurch gekennzeichnet, dass**
mehrere Stellmotoren (15) vorgesehen sind, die mittels einer zentralen Steuer- oder Regeleinheit selektiv ansteuerbar sind.

5. Vorrichtung nach einem der Ansprüche 1 bis 4,
**dadurch gekennzeichnet, dass**
die Druckwalze (2) eine auswechselbare Musterhülse (12) aufweist.

6. Vorrichtung nach einem der Ansprüche 1 bis 5,
**dadurch gekennzeichnet, dass**
mittels der Stelleinrichtung (14) die Druckwalze (2) an die Gegendruckwalze (3) anstellbar und von dieser (3) abstellbar ist.

7. Vorrichtung nach Anspruch 6,
**dadurch gekennzeichnet, dass**
die Stelleinrichtung (14) einen auf einer Führungsschiene (13) gelagerten Führungsschlitten (8) aufweist, auf dem die Druckwalze (2) angeordnet ist.

8. Vorrichtung nach Anspruch 7,
**dadurch gekennzeichnet, dass**
der Führungsschlitten (8) mittels des Stellmotors (15) linear entlang der Führungsschienen (13) verfahrbar ist.

## Claims

1. Apparatus for continuous coating of a strip substrate in a vacuum, in particular for the production of coating patterns on the substrate, with a pressure roller and a counterpressure roller between which the substrate is led, wherein in a working position that can be adjusted by means of an adjusting device the pressure roller and the counterpressure roller are in an active connection with each other such that a coating compound or separating compound can be transferred to the substrate by the pressure roller,
**characterized in that**
the adjusting device (14) is an addressable servo motor (15).

2. Apparatus according to Claim 1,
**characterized in that**
a radial gap (16) between the pressure roller (2) and the counterpressure roller (3) can be adjusted by means of the servo motor (15).

3. Apparatus according to Claim 1 or Claim 2,
**characterized in that**
the servo motor (15) is configured as a stepping motor (15).

4. Apparatus according to any one of Claims 1 to 3,
**characterized in that**
a plurality of servo motors (15), which are selectively addressable by means of a central control or regulating unit, are provided.

5. Apparatus according to any one of Claims 1 to 4,
**characterized in that**
the pressure roller (2) has an exchangeable roller sleeve (12).

6. Apparatus according to any one of Claims 1 to 5,
**characterized in that**
the pressure roller (2) can be adjusted towards and away from the counterpressure roller (3) by means of the adjusting device (14).

7. Apparatus according to Claim 6,
**characterized in that**
the adjusting device (14) has a guide block (8), mounted on a guide rail (13), on which the pressure roller (2) is arranged.

8. Apparatus according to Claim 7,
**characterized in that**
the guide block (8) is linearly traversable along the guide rails (13) by means of the servo motor (15).

## Revendications

1. Dispositif de revêtement sous vide et en continu d'un substrat en forme de bande, destiné en particulier à la formation sur le substrat de motifs de revêtement, comprenant un cylindre presseur et un cylindre de contre-pression, entre lesquels le substrat est guidé, dans lequel, dans une position de travail réglable au moyen d'un dispositif de réglage, le cylindre presseur et le cylindre de contre-pression se trouvent dans une relation fonctionnelle, dans laquelle le cylindre presseur permet de transférer sur le substrat un agent de revêtement ou de séparation,
**caractérisé en ce que**
le dispositif de réglage (14) présente un servomoteur commandable (15).

2. Dispositif selon la revendication 1,
**caractérisé en ce que**
le servomoteur (15) permet de régler une distance radiale (16) entre le cylindre presseur (2) et le cylindre de contre-pression (3).

3. Dispositif selon la revendication 1 ou 2,
**caractérisé en ce que**
le servomoteur (15) est réalisé sous la forme d'un moteur pas à pas (15).

4. Dispositif selon l'une quelconque des revendications 1 à 3,
**caractérisé en ce que**
plusieurs servomoteurs (15) sont prévus qui peuvent être commandés de manière sélective au moyen d'un organe de commande ou de réglage central.

5. Dispositif selon l'une quelconque des revendications 1 à 4,
**caractérisé en ce que**
le cylindre presseur (2) présente un manchon à motif échangeable (12).

6. Dispositif selon l'une quelconque des revendications 1 à 5,
**caractérisé en ce que**
le dispositif de réglage (14) permet de rapprocher le cylindre presseur (2) du cylindre de contre-pression (3) et de le retirer de ce dernier (3).

7. Dispositif selon la revendication 6,
**caractérisé en ce que**
le dispositif de réglage (14) présente un coulisseau (8) qui est logé sur un rail de guidage (13), sur lequel coulisseau est placé le cylindre presseur (2).

8. Dispositif selon la revendication 7,
**caractérisé en ce que**
le servomoteur (15) permet de déplacer le coulisseau (8) linéairement le long des rails de guidage (13).
